# EUROPEAN PATENT SPECIFICATION

(11) **EP 0 587 296 B1**
(45) Date of publication and mention of the grant of the patent: **06.03.2002**
(21) Application number: 93306127.7
(22) Date of filing: 03.08.1993
(51) Int. Cl.: H01L 21/48, H01L 23/495

(54) **Tab tape and method for producing it**
TAB Band und sein Herstellungsverfahren
Bande TAB et procédé pour sa fabrication

(30) Priority: 08.08.1992 JP 23274392
(43) Date of publication of application: 16.03.1994
(73) Proprietor: SHINKO ELECTRIC INDUSTRIES CO. LTD., Nagano-shi, Nagano 380 (JP)
(72) Inventor: Kodani, Kotaro, c/o Shinko Elec. Ind. Co., Ltd., Nagano-shi, Nagano 380 (JP); Koyanagi, Kazuo, c/o Shinko Elec. Ind. Co., Ltd., Nagano-shi, Nagano 380 (JP); Sato, Kiyokazu, c/o Shinko Elec. Ind. Co., Ltd., Nagano-shi, Nagano 380 (JP)
(74) Representative: Rackham, Stephen Neil

(56) References cited:
- EP-A- 0 232 108
- EP-A- 0 469 920
- DE-A- 4 026 822
- US-A- 4 621 278
- PATENT ABSTRACTS OF JAPAN vol. 016, no. 097 (E-1176) 10 March 1992 & JP-A-3 276 739 ( HITACHI LTD. ) 6 December 1991
- PATENT ABSTRACTS OF JAPAN vol. 016, no. 084 (E-1172) 28 February 1992 & JP-A-3 270 026 ( FUJITSU LIMITED ) 2 December 1991
- PATENT ABSTRACTS OF JAPAN vol. 015, no. 514 (E-1150) 27 December 1991 & JP-A-3 225 935 ( TOMOEGAWA PAPER CO. LTD. ) 4 October 1991

## Description

The present invention relates to a tape automated bonding tape, hereinafter referred to as "TAB tape" and a method for producing the same.

A TAB tape known in the art comprises a base film having an electrical insulating property and a conductor pattern formed on the base film. Such a TAB tape is characterized in that it can provide an extremely fine conductor pattern.

For producing a TAB tape, its conductor pattern is made by forming such conductor film as copper foil and the like on base film and then by etching the conductor film in the shape of a required pattern. Since the conductor film is supported on the base film of the TAB tape, it becomes possible to use a conductor film which is much thinner than a conventional metal lead frame and to form a conductor pattern of high-density which cannot be formed by such a conventional metal lead frame.

Because the base film of the TAB tape supports the conductor pattern as mentioned above, this base film itself must have an electrical insulating property. In addition, this base film must have a certain heat-resisting property, since the TAB tape is hermetically sealed with resin after a semiconductor chip is mounted thereon. Therefore, a heat-resisting plastic film such as polyimide film or the like is used as the base film. Such a tape is known from EP-A- 0 232 108

However, such a known TAB tape has the following problems that; the plastic film such as polyimide film or the like used as the base film is relatively expensive material; the base film has moisture-absorbency and this causes cracks in the sealed resin after being hermetically sealed with resin; the adhesiveness between the base and the sealed resin is not always satisfactory, because of the softness and low rigidity to be deformed; the deformations of the sprocket holes formed in the base film cause insufficient positioning accuracy, and the difference between the coefficient of thermal expansion of the conductor pattern and that of the base film causes warps in the attached condition between the base film and the conductor pattern,

According to a first aspect of this invention a process for producing a tape automated bonding tape, the process comprises the steps of:
providing a metal support;
providing an insulating adhesive layer on the metal support;
forming required holes, such as device holes, in the metal support and the adhesive layer;
after hole formation, adhering a conductive metal foil of the same material as the support to the support via said adhesive layer; and
etching the conductive metal foil to form a conductor pattern;
characterised in that, prior to the etching of the conductive metal foil, the metal support is connected to a plating electrode to form a protective electroplated film on the exposed surfaces of the metal support which is not corroded by the etchant used to etch the conductive metal foil.

According to a second aspect of this invention a tape automated bonding tape comprises:
a metal support;
an insulating adhesive layer provided on the metal support;
a conductive pattern formed from a conductive metal foil of the same material as the support which is adhered to the support via said adhesive layer; and,
holes, such as device holes, formed in the metal support and the adhesive layer;
characterised in that a protective electroplated film is provided on the exposed surfaces of the metal support.

The TAB tape of the present invention uses a metal plate as a support instead of using an insulating film such as polyimide film which composes the base film of a known TAB tape. Since the metal plate and the conductor pattern are made of an identical material such as copper, it is possible to restrain warps and the like of a joined body and to obtain TAB tape products of high quality and high precision.

The metal plate and the conductor pattern are electrically insulated from each other by an insulating adhesive layer. In the case where the metal plate is used as a support for the conductor pattern, the TAB tape is produced by the process which comprises forming a device hole, etching copper foil and the like, in the same way as a known TAB tape in which conventional base film is used.

Particular embodiments of TAB tapes and processes for their manufacture in accordance with this invention will now be described with reference to the accompanying drawings, in which:-
Figs. 1(a) to 1(f) show a process for producing a TAB tape in a first embodiment of the present invention;
Fig. 2 is a plan view of the TAB tape made in accordance with the first embodiment;
Figs. 3(a) to 3(f) show a second embodiment of a process for producing a TAB tape;
Figs. 4(a) to 4(h) show a third embodiment of a process for producing a TAB tape; and
Figs. 5(a) to 5(h) show a fourth embodiment of a process for producing a TAB tape.

The TAB tape according to the present invention is characterised in that a metal plate is used as a support for a conductor pattern instead of a base film made of a known plastic base film (for example, polyimide film or the like) and that the conductor pattern is formed on the metal plate with an insulating adhesive layer there-between. That is to say, in a conventionally known TAB tape, the insulating adhesive layer functions as a supporting means for the conductor pattern, while, in the TAB tape in accordance with the present invention, a metal plate functions as a supporting means for the conductor pattern.

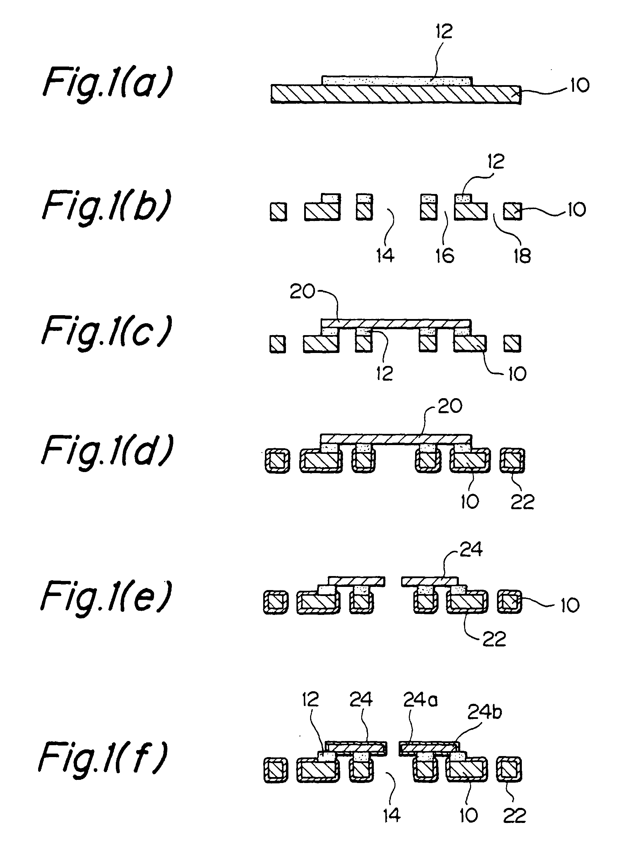

In Figs. 1(a) to 1(f), a first embodiment of a process for producing a TAB tape in accordance with the present invention is shown. Fig. 1(a) shows a metal plate 10 as a support portion for supporting a conductor pattern. The metal plate 10 is provided in the state in which an adhesive 12 for bonding the conductor pattern to it has been already coated as a thin film. The adhesive 12, which is usually an adhesive tape, must have a high-degree electrical insulating property in order to insulate between the metal plate 10 and the conductor pattern. Although the adhesive 12 is not limited to specific kinds, epoxy resin adhesives or polyimide resin adhesives, for example, can advantageously be used.

In this embodiment, a copper plate being 0.125 mm thick is used as the metal plate 10, and the film thickness of the adhesive 12 is from 20 to 30 µm. The metal plate 10 is coated with the adhesive 12 in the overall area on which the conductor pattern is to be formed.

Then, as shown in Fig. 1(b), a device hole 14, window holes 16 and sprocket holes 18 are formed in the metal plate 10 on which the adhesive 12 is applied. These holes are simultaneously formed by a punching process.

Then, as shown in Fig. 1(c), a copper foil 20 is laminated, by a conventional laminating method or roll-coating method, onto the metal plate 10 having the required holes, such as the device hole 14 and the like, formed as mentioned above. In other words, the copper foil 20 is bonded to the metal plate 10 by the adhesive 12 on the metal plate 10 so that the copper foil 20 is laid over each of the holes, except for the sprocket holes 18. After the copper foil 20 is adhered onto the adhesive 12, the tape is heated so that the adhesive 12 is cured.

Then, a conductor pattern is formed by etching the copper foil 20 with such etching agent, such as iron chloride, copper chloride or the like. In this embodiment, however, before etching the copper foil 20, the metal plate 10 is coated with protective plating in order that the plate 10 is prevented from being corroded by the etching agent, as shown in Fig. 1(d).

To perform protective plating, the metal plate 10 is connected to a plating electrode and then electroplating is performed. This makes it possible to form protective plating film 22 only on the metal plate 10. Nickel-electroplating, tin-electroplating, tin and nickel-electroplating, or the like can advantageously be used as protective plating for this purpose.

Then, required conductor pattern 24 is formed by etching the copper foil 20 (Fig. 1(e)). The method of etching the copper foil 20 is similar to those currently in use, and this method comprises applying photoresist on the copper foil 20, exposing and developing this photoresist to form a resist pattern, and then etching the copper foil 20 to form a conductor pattern 24.

Moreover, if photoresist is applied in the condition of Fig. 1(d), it is appropriate to fill the device holes 14 and the window holes 16 with photoresist in order that the copper foil 20 is prevented from being etched from its back side.

After the formation of the conductor pattern 24, the portion of the conductor pattern 24 is plated. The main purpose of this plating is to improve the bonding property of its inner lead portion. Tin-plating, solder-plating, nickel/gold-plating and the like are suitable for this purpose.

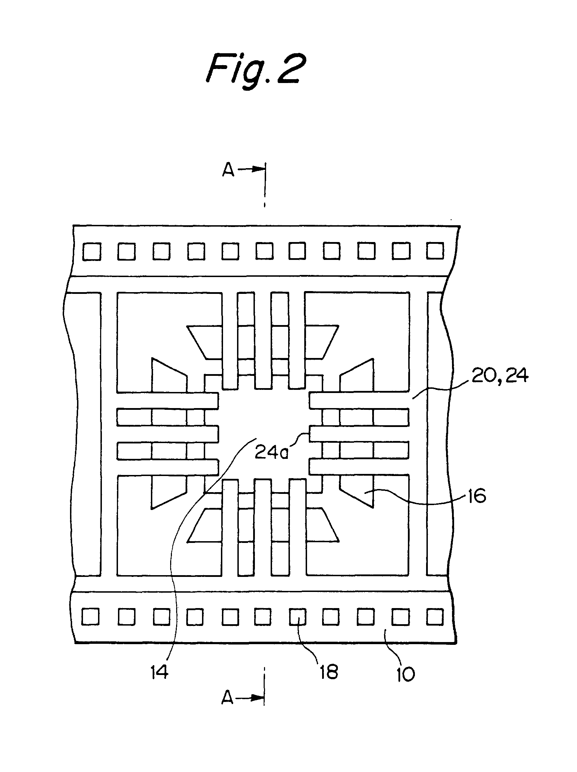

Fig. 2 is a plan view of a product of the TAB tape thus obtained and Fig. 1(f) shows this TAB tape in cross-section along line A-A in Fig. 2. The construction of this product is characterized in that the conductor pattern 24 is supported by the metal plate 10 with the adhesive 12 therebetween. The adhesive 12 insulates the conductor pattern 24 from the metal plate 10. The method for loading a semiconductor chip onto this TAB tape product is similar to that in use for conventional TAB tape products; and it is possible to load a semiconductor chip by joining it to a inner lead 24a with bumps therebetween, so that the semiconductor chip is located in the central device hole 14.

In the first embodiment as described above, since copper is used as the material of the metal plate 10, the metal plate 10 is coated with protective plating in order that this plate 10 is prevented from being etched, simultaneously with the etching of the copper foil 20. However, if the metal plate 10 is made of a metal material which is resistant against the etchant for the copper foil 20, protective plating will not be necessary.

However, in the case in which the material of the conductor pattern 24 and that of the metal plate are different from each other, a problem rises that the TAB tape will become warped because of the difference between their coefficients of heat expansion. Therefore, it is appropriate to use the same metal material for both of the conductor pattern 24 and the metal plate 10. It is generally adequate to use a copper material for the metal plate 10 since the copper material is suitably used for the conductor pattern 24 because of the electrical properties of this material.

Further, conductor metal foil of any suitable material may be used instead of the copper foil 20. In this case, when the same metal material is used for both of the metal plate 10 and said conductor metal foil, it is necessary to perform the same operations as those mentioned above.

Futhermore, since the TAB tape is hermetically sealed with resin after having been loaded with a semiconductor chip, it is required that the TAB tape adheres to the sealing-resin to prevent the exfoliation and the like of the sealing-resin. Therefore it is advantageous to form the surfaces of the metal plate 10 into coarse surfaces. By forming the surfaces of metal plate into coarse surfaces, the bond strength of the adhesive 12 is improved, and reliable support for the conductor pattern 24 is achieved.

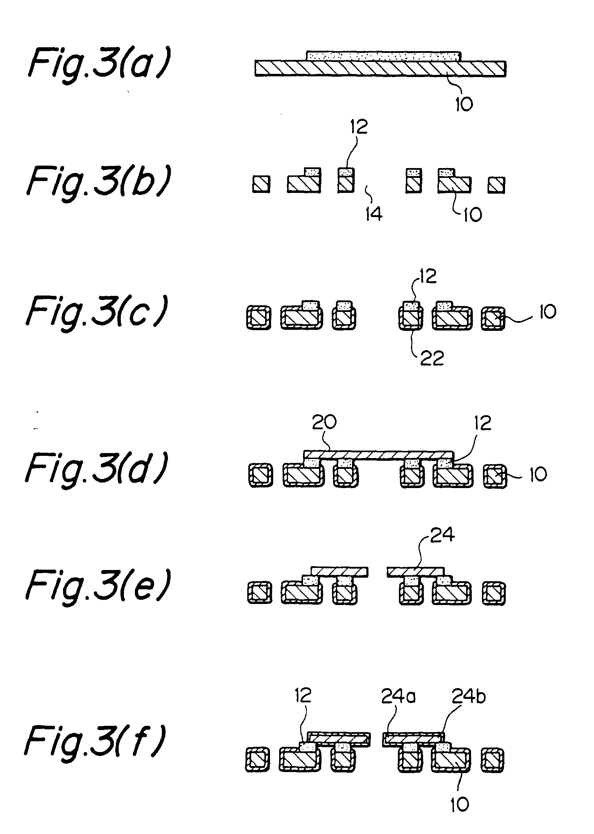

Figs. 3(a) to 3(f) show a second embodiment of the method for producing a TAB tape in accordance with the present invention. This embodiment is substantially the same as the embodiment described above, but is characterized in that the metal plate 10 is coated with the protective plating before the copper foil 20 is bonded onto it.

That is to say, in the embodiment described above in which the metal plate 10 is coated with the protective plating after the copper foil 20 is bonded to it, the layer of the adhesive is so thin (between 20 and 30 µm) that the electrical conduction between the metal plate 10 and the copper foil 20 may occur and the protective plating may attach to the copper foil 20.

Accordingly, it is the aim of this second embodiment shown in Fig. 3 to avoid the electrical conduction between the metal plate 10 and the copper foil 20 by coating the metal plate 10 with the protective plating before bonding the copper foil 20 to it.

Fig. 3(a) shows the metal plate 10 which is used as a support for the conductor pattern and which is provided after being coated with the adhesive 12. This metal plate 10 undergoes a punching process for the formation of the device hole 14 and the like (Fig. 3(b)).

Then, in order that the metal plate 10 is prevented from being corroded by the etchant, protective electroplating is applied to the metal plate 10 in which the device hole 14 and the like have been formed. The protective plating film 22 is formed over the metal plate 10 except for the area having adhesive 12 on it (Fig. 3(c)).

Furthermore, the copper foil 20 is bonded onto the metal plate 10 (Fig. 3(d)), the adhesive 12 is cured by a heating process, the copper foil 20 is etched in the shape of the required pattern, and then, as a result, the conductor pattern 24 is formed (Fig. 3(e)). The method for etching the copper foil 20 and the other processes are the same as those of the first embodiment described above.

Finally, the conductor pattern 24 is plated and the TAB tape is obtained (Fig. 3(f)). The shape of the product thus obtained is substantially the same as that obtained by the method of the first embodiment as described above.

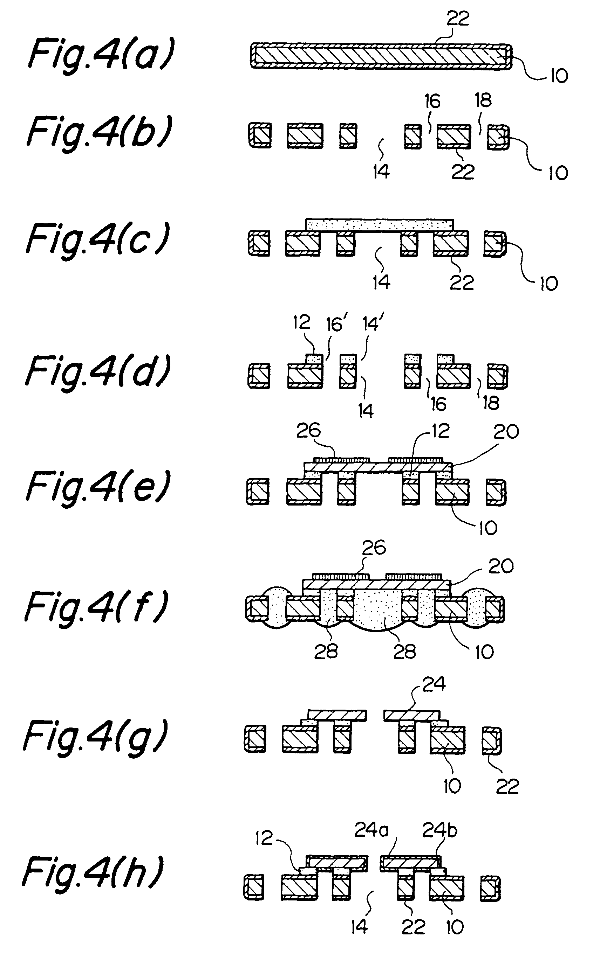

Figs. 4(a) to 4(h) show a third embodiment of the method for producing a TAB tape in accordance with the present invention. This embodiment is characterized in that the metal plate 10 is previously coated with the protective plating and the adhesive 12 is applied to this metal plate 10 having the protective plating on it. Such protective plating may be either electroplating or electroless plating.

In each of the above-mentioned first and second embodiments, since the metal plate 10 is coated with the protective plating after being coated with the adhesive 12, there is a possibility that the protective plating attaches to the portion of the adhesive 12 and, as a result, the electrical insulating function provided by the adhesive 12 is hindered. In this third embodiment, the metal plate 10 is previously coated with the protective plating in order that the electrical insulating function of the adhesive 12 can be prevented from being hindered.

Fig. 4(a) shows the metal plate 10 coated with the protective plating. The purpose of this protective plating is, as described above, to prevent the metal plate 10 from being corroded during etching of the copper foil 20. Such required holes as the device hole 14 and the like are formed by a punching process in the metal plate 10 coated with the protective plating (Fig. 4(b)).

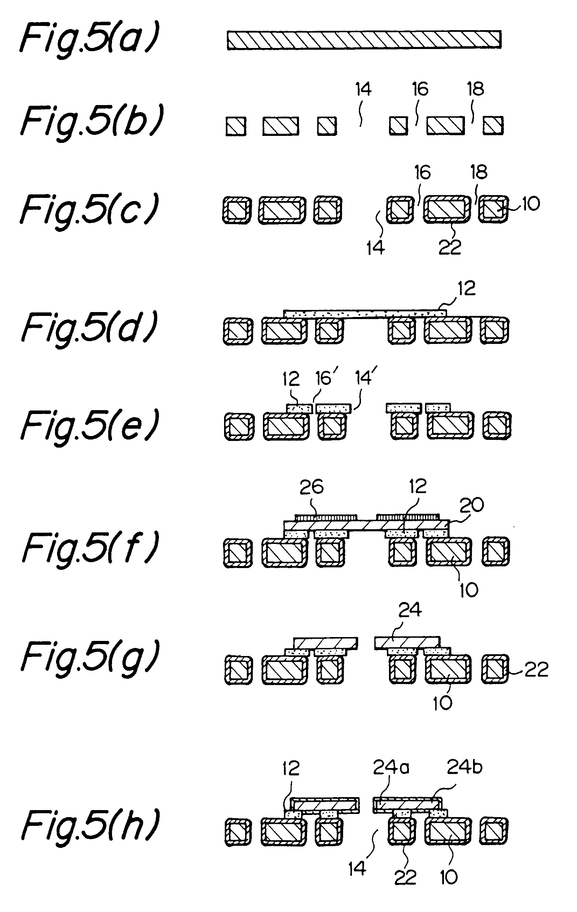

Furthermore, the adhesive 12 is applied or laminated to the required area on the metal plate 10 (Fig. 4(c)). Then, the adhesive 12, usually adhesive tape, is formed with device hole 14' and window holes 16' corresponding to the device hole 14 and the window holes 16 of the metal plate 10 (Fig. 4(d)). In this case, device hole 14' and window holes 16' may be formed so as to be smaller than the device hole 14 and window holes 16, respectively, as will be described later with reference to Fig. 5(e). Then, the copper foil 20 is bonded on the metal plate 10 by means of the adhesive 12. The adhesive 12 is than cured by a heating process.

Fig. 4(e) shows the condition in which a resist pattern 26 has been formed on the top of the copper foil 20. This resist pattern 26 is used for the etching of the copper foil 20 in the shape of its required pattern.

In the third embodiment, the device hole 14 and the like are formed by a punching process in the metal plate 10 previously coated with the protective plating. Consequently, the inner sides of each of the hole portions such as device hole 14 and the like are not coated with the protective plating. As indicated in Fig. 4(f), when the copper foil 20 is to be etched, the hole portions of the metal plate 10 are filled with protective resist 28 at the same time that the resist pattern is formed, and the etching of the copper foil 20 is performed so that the etching of the metal plate 10 can be prevented.

Fig. 4(g) shows the condition in which the protective resist 28 has already been removed after the etching of the copper foil 20 and the formation of the conductor pattern 24.

After the formation of the conductor pattern 24 is accomplished as described above, the conductor pattern 24 is plated and a TAB tape product is obtained (Fig. 4(h)). In the same manner as the TAB tape products of the other embodiments mentioned above, this TAB tape product obtained has the construction in which the metal plate 10 supports inner leads 24a and outer leads 24b with the adhesive 12 between the metal plate and these leads.

However, this third embodiment is different from the first and second embodiments mentioned above in that the adhesive 12 is located on the protective plating film 22 and in that the protective plating film 22 is not formed on the inner walls of the hole portions such as the device hall 14 and the like of metal plate 10.

Figs. 5(a) to 5(h) show a fourth embodiment of the method for producing a TAB tape in accordance with the present invention. This embodiment is characterized in that the metal plate 10 is first formed with required holes, such as a device hole 14, window holes 16 and sprocket holes 18, before the metal plate 10 is coated with the protective plating.

Fig. 5(a) shows the metal plate 10. Then, the required holes, such as the device hole 14, the window holes 16 and the sprocket holes 18, are formed by a punching process in the metal plate 10 (Fig. 5(b)). Then, the metal plate 10 is coated with the protective plating 22 (Fig. 5(c)). The purpose of this protective plating is the same as described above. However, this embodiment is different from the previous, third embodiment that the protective plating film 22 is also formed on the inner walls of the hole portions such as the device hall 14 and the like of metal plate 10.

Then, the adhesive 12 is applied or laminated to the required area on the metal plate 10 (Fig. 5(d)). Then, the adhesive 12, usually adhesive tape, is formed with device hole 14' and windows holes 16' corresponding to the device hole 14 and the windows holes 16 of the metal plate 10 (Fig. 5(e)). In this case, device hole 14' and windows holes 16' of the adhesive tape 12 are formed so as to be smaller than the device hole 14 and windows holes 16 of the metal plate 10, respectively, so that the inside edge of the device hole 14' of the adhesive 12 extends by about 0.2 mm from the inside edge of the device hole 14 of the metal plate 10 and, in the same manner the inside edge of the window holes 16' of the adhesive 12 also extend by about 0.2 mm from the inside edge of the window holes 16 of the metal plate 10. Then, the copper foil 20 is bonded on the metal plate 10 by means of the adhesive 12. After the copper foil 20 is adhered to the adhesive 12, the tape is heated so that the adhesive 12 is cured.

Fig. 5(f) shows the condition in which a resist pattern 26 has been formed on the top of the copper foil 20.

In the fourth embodiment, the device hole 14 and the like are formed by a punching process in the metal plate 10 before the metal plate 10 is coated with the protective plating 20. Consequently, the inner sides of each of the hole portions such as device hole 14 and the like are also coated with the protective plating and, in addition, such holes are also protected by the extended portions (14' and 16') of the adhesive 12. In Fig. 5(g), the etching of the copper foil 20 is performed so that the etching of the metal plate 10 can be prevented by the protective plated film 22 and also the extended portions (14' and 16') of the adhesive 12.

After the conductor pattern 24 is formed by an etching process, as described above, the conductor pattern 24 is plated and a TAB tape product is obtained (Fig. 5(h)). In the same manner as the TAB tape products of the other embodiments mentioned above, this TAB tape product obtained has the construction in which the metal plate 10 supports inner leads 24a and outer leads 24b with the adhesive 12 between the metal plate and these leads.

In this fourth embodiment, since the inner sides of each of the hole portions, such as device hole 14 and the like, are also coated with the protective plating and, in addition, such holes are also protected by the extended portions (14' and 16') of the adhesive 12, as described above, the possibility of a short circuit or an electric leakage between the conductor pattern 24 and the metal plate 10 can significantly be reduced.

In each of the embodiments mentioned above, the TAB tape product was that having a single layer of conductor pattern 12 placed on the metal plate 10, while an additional adhesive layer having an electric insulating property in the same way as the adhesive layers of the embodiments mentioned above can be placed between the layers in order that a multilayer conductor pattern is achieved.

The methods for producing a TAB tape product shown in each of the embodiments mentioned above are substantially the same as the known methods for producing TAB tape products which use such base film as polyimide film and the like having an electrical insulating property. Consequently, the-method according to the present invention is characterized in that the current production equipment for producing TAB tapes can effectively be utilized for the production of the TAB tapes in accordance with the present invention. Therefore, a waste of this equipment can be avoided.

Furthermore, since the TAB tape in accordance with the present invention uses a metal plate instead of such known base film as polyimide film or the like, this TAB tape has following advantages; by using a metal plate, its material cost is made cheaper than in the case where such base film as polyimide or the like is used; the deformation of the conductor pattern can effectively be restrained because the rigidity of the metal plate is higher than that of the base film; and positioning accuracy is improved since the deformation of the sprocket holes can be restrained.

Furthermore, in a known TAB tape the conductor pattern is supported on the base film and the junction between the two different materials causes warps, but, in contrast, in the TAB tape according to the present invention, the material of the metal plate is the same as that of the conductor pattern, and it becomes possible to restrain the warps caused by the junction between the two different materials. Furthermore, such known base film such as polyimide film or the like has following disadvantages; the adhesion quality between sealing resin and base film is insufficient when the TAB product is hermetically sealed with resin; and the base film material is absorbent. In contrast, in the TAB tape according to the present invention, since a non-absorbent metal plate is used instead of base film, it becomes possible to improve the adhesion quality to the sealing resin and to obtain highly reliable products.

In accordance with the TAB tape and the method for producing it of the present invention, as described above, it is possible to obtain TAB tape products of high quality and high precision and to provide them as products which can be suitably resin-sealed. Since the support member is made of a metal material, the TAB tape can easily be loaded on, such as, a circuit board of a semiconductor device in a state that the support member is bent in a desired sahpe with the conductor pattern. Furthermore, the method in accordance with the present invention makes it possible to reduce material costs and to produce TAB tape products more simply than known such products without further complicating the producing process. The present invention also provides other remarkable advantages.

## Claims

1. A process for producing a tape automated bonding tape, the process comprising the steps of:
providing a metal support (10);
providing an insulating adhesive layer (12) on the metal support (10);
forming required holes (14;16;18), such as device holes, in the metal support (10) and the adhesive layer (12);
after hole formation, adhering a conductive metal foil (20) of the same material as the support to the support via said adhesive layer; and
etching the conductive metal foil (20) to form a conductor pattern (24);
**characterised in that**, prior to the etching of the conductive metal foil (20), the metal support (10) is connected to a plating electrode to form a protective electroplated film (22) on the exposed surfaces of the metal support (10) which is not corroded by the etchant used to etch the conductive metal foil (20).

2. A method according to claim 1, in which the required holes (14;16;18) are formed in the metal support (10) and the insulating adhesive layer (12) after forming the insulating adhesive layer (12) on the support, and prior to forming the protective electroplated film (22).

3. A method according to claim 2, in which the conductive metal foil (20) is adhered to the metal support (10) prior to forming the protective electroplated film (22).

4. A method according to claim 2, in which the protective electroplated film (22) is formed prior to the adhesion of the conductive metal foil (20).

5. A method according to claim 1, in which the protective electroplated film (22) is formed prior to the provision of the adhesive layer (12) and the required holes (14;16;18) are formed in the metal support (10) and the protective electroplated film (22) after forming the protective electroplated film (22), and prior to forming the insulating adhesive layer (12).

6. A method according to claim 5, in which the holes (14;16;18) are filled with a protective resist (28) prior to etching the conductive metal foil (20) and wherein the protective resist (28) is removed after etching of the conductive metal foil (20).

7. A method according to claim 1, in which the required holes (14;16;18) are formed in the metal support (10) prior to forming the insulating adhesive layer (12) and protective electroplated film (22).

8. A method according to claim 7 in which the required holes (14';16') in the insulating adhesive layer (12) are smaller than the corresponding holes (14;16) in the metal support (10), so that an inside edge of the holes in the insulating adhesive layer extend over a portion of the corresponding holes in the metal support (10).

9. A method according to any one of the preceding claims, in which the conductor pattern is plated with tin, solder or nickel-gold to improve its bonding properties.

10. A method according to any one of the preceding claims, in which the insulating adhesive layer (12) is an epoxy resin or polyimide resin adhesive.

11. A method according to any one of the preceding claims, in which the metal support (10) and the conductive metal foil (20) are made of copper.

12. A tape automated bonding tape comprising:
a metal support (10);
an insulating adhesive layer (12) provided on the metal support (10);
a conductive pattern (24) formed from a conductive metal foil (20) of the same material as the support which is adhered to the support via said adhesive layer (12); and,
holes (14;16;18), such as device holes, formed in the metal support (10) and the adhesive layer (12);
**characterised in that** a protective electroplated film (22) is provided on the exposed surfaces of the metal support.

13. A tape automated bonding tape according to claim 12 wherein the required holes (14';16') in the insulating layer (12) are smaller than the required holes (14;16) in the metal support (10) so that an inside edge of the holes (14';16') in the insulating adhesive layer (12) extend over a portion of the corresponding holes (14;16) in the metal support (10).

14. A tape automated bonding tape according to claim 12, in which the conductor pattern (24) is plated with tin, solder or nickel-gold to improve its bonding properties.

15. A tape automated bonding tape according to any one of claims 12 to 14, in which the insulating adhesive layer (12) is an epoxy resin or polyimide resin adhesive.

16. A tape automated bonding tape according to any one of claims 12 to 15, in which the metal support (10) and the conductive metal foil (20) are made of copper.

## Patentansprüche

1. Verfahren zum Herstellen eines Bandes für ein automatisches Folienbondverfahren, wobei das Verfahren die Schritte umfaßt:
Vorsehen eines Metallträgers (10);
Vorsehen einer isolierenden Haftschicht (12) auf dem Metallträger (10);
Bilden erforderlicher Löcher (14; 16; 18), wie z.B. Bauelementlöcher, in dem Metallträger (10) und der Haftschicht (12);
Kleben, nach einer Lochbildung, einer leitfähigen Metallfolie (20) aus dem gleichen Material wie der Träger über die Haftschicht an den Träger; und
Ätzen der leitfähigen Metallfolie (20), um ein Leitermuster (24) zu bilden;
**dadurch gekennzeichnet, daß** vor dem Ätzen der leitfähigen Metallfolie (20) der Metallträger (10) mit einer Galvanisierelektrode verbunden wird, um einen schützenden galvanisierten Film (22) auf den freigelegten Oberflächen des Metallträgers (10) zu bilden, der durch das Ätzmittel, das verwendet wird, um die leitfähige Metallfolie (20) zu ätzen, nicht korrodiert wird.

2. Verfahren nach Anspruch 1, in welchem die erforderlichen Löcher (14; 16; 18) in dem Metallträger (10) und der isolierenden Haftschicht (12) nach einem Bilden der isolierenden Haftschicht (12) auf dem Träger und vor einem Bilden des schützenden galvanisierten Films (22) gebildet werden.

3. Verfahren nach Anspruch 2, in welchem die leitfähige Metallfolie (20) vor einem Ausbilden des schützenden galvanisierten Films (22) an den Metallträger (10) geklebt wird.

4. Verfahren nach Anspruch 2, in welchem der schützende galvanisierte Film (22) vor dem Kleben der leitfähigen Metallfolie (20) gebildet wird.

5. Verfahren nach Anspruch 1, in welchem der schützende galvanisierte Film (22) vor dem Vorsehen der Haftschicht (12) gebildet wird und die erforderlichen Löcher (14; 16; 18) in dem Metallträger (10) und dem schützenden galvanisierten Film (22) nach Bilden des schützenden galvanisierten Films (22) und vor Bilden der isolierenden Haftschicht (12) geschaffen werden.

6. Verfahren nach Anspruch 5, in welchem die Löcher (14; 16; 18) vor einem Ätzen der leitfähigen Metallfolie (20) mit einem schützenden Resist (28) gefüllt werden und worin das schützende Resist (28) nach Ätzen der leitfähigen Metallfolie (20) entfernt wird.

7. Verfahren nach Anspruch 1, in welchem die erforderlichen Löcher (14; 16; 18) in dem Metallträger (10) vor einem Bilden der isolierenden Haftschicht (12) und des schützenden galvanisierten Films (22) gebildet werden.

8. Verfahren nach Anspruch 7, in welchem die erforderlichen Löcher (14'; 16') in der isolierenden Haftschicht (12) kleiner als die entsprechenden Löcher (14; 16) in dem Metallträger (10) sind, so daß sich Innenränder der Löcher in der isolierenden Haftschicht über einen Teil der entsprechenden Löcher in dem Metallträger (10) erstrecken.

9. Verfahren nach einem der vorhergehenden Ansprüche, in welchem das Leitermuster mit Zinn, Lötzinn oder Nickelgold galvanisiert wird, um seine Bondeigenschaften zu verbessern.

10. Verfahren nach einem der vorhergehenden Ansprüche, in welchem die schützende Haftschicht (12) ein Haftmittel aus Epoxidharz oder Polyimidharz ist.

11. Verfahren nach einem der vorhergehenden Ansprüche, in welchem der Metallträger (10) und die leitfähige Metallfolie (20) aus Kupfer hergestellt sind.

12. Band für ein automatisches Folienbondverfahren mit:
einem Metallträger (10);
einer auf dem Metallträger (10) vorgesehenen isolierenden Haftschicht (12);
einem leitfähigen Muster (24), das aus einer leitfähigen Metallfolie (20) des gleichen Materials wie der Träger gebildet ist, welche über die Haftschicht (12) an den Träger geklebt ist; und
Löcher (14; 16; 18), wie z.B. Bauelementlöcher, die in dem Metallträger (10) und der Haftschicht (12) ausgebildet sind;
**dadurch gekennzeichnet, daß** auf den freigelegten Oberflächen des Metallträgers ein schützender galvanisierter Film (22) vorgesehen ist.

13. Band für ein automatisches Folienbondverfahren nach Anspruch 12, worin die erforderlichen Löcher (14'; 16') in der isolierenden Schicht (12) kleiner als die erforderlichen Löcher (14; 16) in dem Metallträger (10) sind, so daß sich Innenränder der Löcher (14'; 16') in der isolierenden Haftschicht (12) über einen Teil der entsprechenden Löcher (14; 16) im Metallträger (10) erstrecken.

14. Band für ein automatisches Folienbondverfahren nach Anspruch 12, in welchem das Leitermuster (24) mit Zinn, Lötzinn oder Nickelgold galvanisiert ist, um seine Bondeigenschaften zu verbessern.

15. Band für ein automatisches Folienbondverfahren nach einem der Ansprüche 12 bis 14, in welchem die isolierende Haftschicht (12) ein Haftmittel aus Epoxidharz oder Polyimidharz ist.

16. Band für ein automatisches Folienbondverfahren nach einem der Ansprüche 12 bis 15, in welchem der Metallträger (10) und die leitfähige Metallfolie (20) aus Kupfer hergestellt sind.

## Revendications

1. Procédé pour produire une bande pour soudage automatisé sur bande, le procédé comprenant les étapes dans lesquelles :
on se procure un support métallique (10) ;
on se procure une couche adhésive isolante (12) sur le support métallique (10) ;
on forme les trous nécessaires (14 ; 16 ; 18), tels que des trous pour dispositif, dans le support métallique (10) et dans la couche adhésive (12) ;
après la formation des trous, on fait adhérer une mince feuille métallique conductrice (20) de la même matière que celle du support au support par l'intermédiaire de ladite couche adhésive ; et
on attaque chimiquement la mince feuille métallique conductrice (20) pour former un motif conducteur (24) ;
**caractérisé en ce que**, avant l'attaque chimique de la mince feuille métallique conductrice (20), le support métallique (10) est connecté à une électrode de dépôt pour former un film électrodéposé protecteur (22) sur les surfaces à découvert du support métallique (10) qui n'est pas corrodé par l'agent d'attaque utilisé pour attaquer la mince feuille métallique conductrice (20).

2. Procédé selon la revendication 1, dans lequel les trous nécessaires (14 ; 16 ; 18) sont formés dans le support métallique (10) et dans la couche adhésive isolante (12) après la formation de la couche adhésive isolante (12) sur le support, et avant la formation du film électrodéposé protecteur (22).

3. Procédé selon la revendication 2, dans lequel la mince feuille métallique conductrice (20) est collée au support métallique (10) avant la formation du film électrodéposé protecteur (22).

4. Procédé selon la revendication 2, dans lequel le film électrodéposé protecteur (22) est formé avant le collage de la mince feuille métallique conductrice (20).

5. Procédé selon la revendication 1, dans lequel le film électrodéposé protecteur (22) est formé avant l'application de la couche adhésive (12) et les trous nécessaires (14 ; 16 ; 18) sont formés dans le support métallique (10) et dans le film électrodéposé protecteur (22) après la formation du film électrodéposé protecteur (22), et avant la formation de la couche adhésive isolante (12).

6. Procédé selon la revendication 5, dans lequel les trous (14 ; 16 ; 18) sont remplis d'un résist protecteur (28) avant l'attaque chimique de la mince feuille métallique conductrice (20), et dans lequel le résist protecteur (28) est enlevé après l'attaque chimique de la mince feuille métallique conductrice (20).

7. Procédé selon la revendication 1, dans lequel les trous nécessaires (14 ; 16 ; 18) sont formés dans le support métallique (10) avant la formation de la couche adhésive isolante (12) et du film électrodéposé protecteur (22).

8. Procédé selon la revendication 7, dans lequel les trous nécessaires (14' ; 16') dans la couche adhésive isolante (12) sont plus petits que les trous correspondants (14 ; 16) dans le support métallique (10), afin qu'un bord intérieur des trous dans la couche adhésive isolante s'étende sur une partie du trou correspondant dans le support métallique (10).

9. Procédé selon l'une quelconque des revendications précédentes, dans lequel le motif conducteur est revêtu d'étain, de soudure tendre ou de nickel-or pour améliorer ses propriétés de liaison.

10. Procédé selon l'une quelconque des revendications précédentes, dans lequel la couche adhésive isolante (12) est un adhésif en résine époxy ou résine du type polyimide.

11. Procédé selon l'une quelconque des revendications précédentes, dans lequel le support métallique (10) et la mince feuille métallique conductrice (20) sont constitués de cuivre.

12. Bande pour soudage automatisé sur bande comportant :
un support métallique (10) ;
une couche adhésive isolante (12) située sur le support métallique (10) ;
un motif conducteur (24) formé dans une mince feuille métallique conductrice (20) constituée de la même matière que celle du support qui est collée au support par l'intermédiaire de ladite couche adhésive (12) ; et
des trous (14 ; 16 ; 18), tels que des trous pour dispositif, formés dans le support métallique (10) et la couche adhésive (12) ;
**caractérisée en ce qu'**un film électrodéposé protecteur (22) est appliqué sur les surfaces à découvert du support métallique.

13. Bande pour soudage automatisé sur bande selon la revendication 12, dans laquelle les trous nécessaires (14' ; 16') dans la couche isolante (12) sont plus petits que les trous nécessaires (14 ; 16) dans le support métallique (10) afin qu'un bord intérieur des trous (14' ; 16') dans la couche adhésive isolante (12) s'étende au-dessus d'une partie des trous correspondants (14 ; 16) dans le support métallique (10).

14. Bande pour soudage automatisé sur bande selon la revendication 12, dans laquelle le motif conducteur (24) est revêtu d'étain, de soudure tendre ou de nickel-or pour améliorer ses propriétés de liaison.

15. Bande pour soudage automatisé sur bande selon l'une quelconque des revendications 12 à 14, dans laquelle la couche adhésive isolante (12) est un adhésif à résine époxy ou résine du type polyimide.

16. Bande pour soudage automatisé sur bande selon l'une quelconque des revendications 12 à 15, dans laquelle le support métallique (10) et la mince feuille métallique conductrice (20) sont formés de cuivre.
